# EUROPEAN PATENT SPECIFICATION

(11) **EP 0 411 916 B1**
(45) Date of publication and mention of the grant of the patent: **04.06.1997**
(21) Application number: 90308447.3
(22) Date of filing: 31.07.1990
(51) Int. Cl.: G03F 7/20

(54) **Wafer table and exposure apparatus with the same**
Wafertisch und damit versehene Belichtungsvorrichtung
Table pour plaquette et appareil d'exposition muni d'une telle table

(30) Priority: 01.08.1989 JP 197957/89
(43) Date of publication of application: 06.02.1991
(73) Proprietor: CANON KABUSHIKI KAISHA, Tokyo (JP)
(72) Inventor: Amemiya, Mitsuaki, c/o Canon Kabushiki Kaisha, Ohta-ku, Tokyo (JP); Sakamoto, Eiji, c/o Canon Kabushiki Kaisha, Ohta-ku, Tokyo (JP); Uda, Koji, c/o Canon Kabushiki Kaisha, Ohta-ku, Tokyo (JP); Ozawa, Kunitaka, c/o Canon Kabushiki Kaisha, Ohta-ku, Tokyo (JP); Iwamoto, Kazunori, c/o Canon Kabushiki Kaisha, Ohta-ku, Tokyo (JP); Uzawa, Shunichi, c/o Canon Kabushiki Kaisha, Ohta-ku, Tokyo (JP); Marumo, Mitsuji, c/o Canon Kabushiki Kaisha, Ohta-ku, Tokyo (JP)
(74) Representative: Beresford, Keith Denis Lewis

(56) References cited:
- EP-A- 0 320 297
- EP-A- 0 357 423
- DE-A- 3 213 239
- DE-A- 3 306 999

## Description

This invention relates to an exposure apparatus including a wafer table having a carrying surface for carrying a wafer , wherein the wafer table has a function for controlling the temperature of the wafer placed on the carrying surface.

In a semiconductor lithographic process, an exposure apparatus is used to expose a wafer to a mask with an appropriate exposure energy to thereby transfer a pattern, formed on the mask, onto the wafer. In such lithographic process, it is necessary to exactly control the temperature of a wafer, in order to assure that the pattern of a mask is transferred to the wafer at high precision. This is, in one aspect, for preventing thermal distortion of the wafer due to temperature rise of the same during the exposure operation by the exposure energy and, in another aspect, for removing any process distortion as disclosed in Japanese Laid-Open Patent Application JP-A-53-015768, wherein the temperature of a wafer is controlled so as to correct, before start of exposure, any magnification error through thermal contraction.

Conventionally, the temperature of a wafer is controlled by flowing a temperature adjusting fluid, such as a constant temperature water, through the inside of a wafer carrying table.

With this method, however, the passage of the constant-temperature water through the passageway in the wafer table does transmit disturbance to the wafer table and, as a result of which, the wafer table itself vibrates. This leads to a possibility of degradation of the resolution or the positioning accuracy.

Further, the tendency to miniaturization of a pattern to be transferred has forced control of the wafer temperature in an order of ±0.01 (deg) and, therefore, the temperature control of the wafer for the temperature adjustment has to bear a large burden.

DE-A-3306999 discloses an exposure apparatus including a table having a wafer holding surface, a Peltier device arranged beneath the holding surface, and a passageway permitting water to pass under said Peltier device, said table also having temperature measuring means.

An object of the present invention is to provide an exposure apparatus which is effective to prevent vibration of the wafer table due to the flow of constant temperature water and, also, which is effective to reduce the burden in regard to the temperature control of the constant temperature water.

According to the invention there is provided an exposure apparatus for exposing a wafer with radiation, comprising a table having a holding surface for holding said wafer; a flow passageway through which temperature adjusting medium can flow to remove heat in said table; a temperature adjusting device disposed between said holding surface and said flow passageway and adapted to actively heat or cool said holding surface; and flow rate controlling means for controlling the flow rate of said temperature adjusting medium circulated through said flow passageway;
characterised by control means adapted to control said flow rate controlling means to decrease the flow rate of said temperature adjusting medium during an exposure period in which said wafer is exposed with the radiation and/or during aligning of said wafer on said table as compared with the flow rate during a non exposure and/or non alignment period such that any vibration resulting from the flow of said temperature adjusting medium is not substantially influential to the exposure precision and/or the alignment precision.

In such exposure apparatus, during the wafer exposure operation or the alignment and exposure operation, flow rate controlling means operates to reduce the flow rate of the temperature adjusting medium such that any vibration resulting from the flow of the temperature adjusting medium is not substantially influential to the exposure precision or the alignment precision.

In this structure, for exposure or pattern drawing of a wafer or, alternatively, for positioning of the wafer, the temperature of the wafer is controlled only by the temperature controlling means or, alternatively, by the combination of the temperature controlling means and the temperature adjusting medium whose flow rate is restricted by the flow rate controlling means to a level not causing the effect of vibration. As a result, the exposure or pattern drawing, or, the positioning of the wafer can be executed precisely, without being influenced by the vibration. The temperature control of the wafer through the temperature controlling means may be effected, for example, by transmitting the heat of the wafer to the flow passageway side, for circulation of the temperature adjusting medium or, alternatively, by heating the wafer. In any way, the temperature control is effected relatively finely and exactly. During a time period other than that for the exposure or pattern drawing of the wafer or the positioning of the same, a small vibration does not cause any inconvenience. Accordingly, the flow rate controlling means uses a sufficient flow rate of the temperature adjusting medium to discharge the heat accumulated in the wafer table by the exposure or the like. Accordingly, with the present invention, the exposure process of a wafer can be executed while assuring the temperature control and the vibration prevention at the same time.

According to the present invention there is also provided an exposure method for exposing a wafer with radiation, comprising holding said wafer on a wafer holding surface of a table) with attraction; actively heating or cooling said wafer held by said wafer holding surface using a temperature adjusting device said temperature adjusting device being disposed between said wafer holding surface and a flow passageway through which a temperature adjusting medium can flow for removal of heat in said table; characterised in that whilst said wafer is exposed with the radiation and/or said wafer is aligned on said table, the flow rate of the temperature adjusting medium supplied through said flow passageway is reduced, as compared with the flow rate of the temperature adjusting medium flowing through said flow passageway during a period in which said wafer is not exposed with the radiation and/or aligned on said table such that any vibration resulting from the flow of the temperature adjusting medium is not substantially influential to the exposure precision and/or the alignment precision.

Embodiments of the present invention will now be described with reference to the accompanying drawings in which:

Figure 1 is a schematic and diagrammatic view of an exposure apparatus with a wafer table, according to an embodiment of the present invention.

Figure 2 is a flow chart, for explaining the operation of the Figure 1 embodiment.

Figure 3 is a schematic and diagrammatic view of an exposure apparatus with a wafer table, according to another embodiment of the present invention.

Figure 4 is a schematic and diagrammatic view of an exposure apparatus with a wafer table, according to a further embodiment of the present invention.

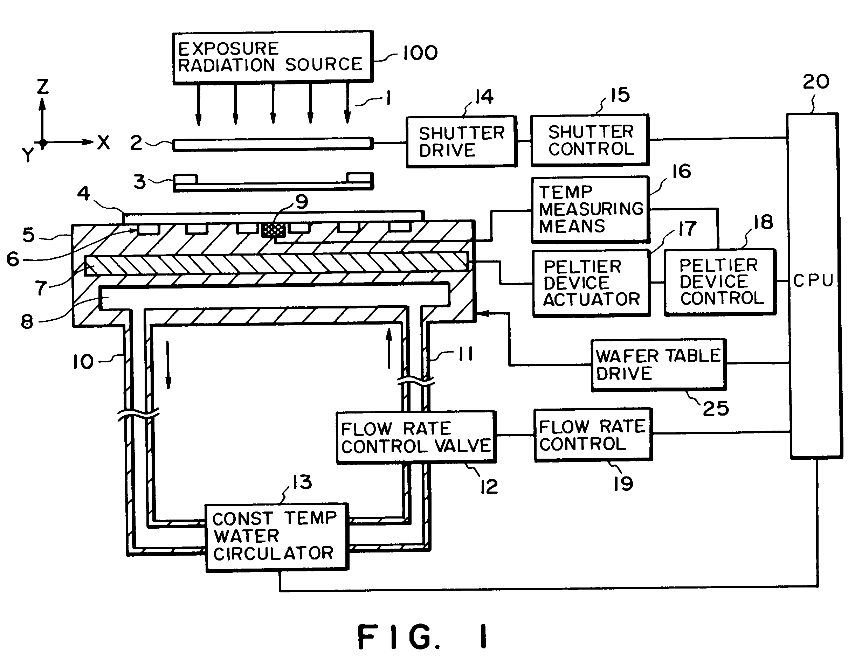

Figure 1 schematically illustrates a step-and-repeat type exposure apparatus with a wafer table, according to an embodiment of the present invention. In Figure 1, denoted at 1 is an exposure radiation energy such as light or X-rays, for example, supplied from an exposure radiation source 100; at 2 is a shutter for defining a desired exposure time; at 3 is a mask; and at 4 is a wafer. The mask 3 and the wafer 4 are disposed opposed to each other and substantially in parallel to an X-Y plane, with a small gap maintained therebetween. The irradiation of the mask 3 and the wafer 4 with the exposure radiation energy 1 is controlled by opening/closing of the shutter 2. Denoted at 5 is a wafer table for holding the wafer 4 thereon. The wafer table is provided with vacuum grooves 6 for holding by vacuum the wafer 4 on its wafer holding surface, a Peltier device 7 effective to transmit the thermal energy produced inside the wafer table by the exposure radiation rays 1 to a constant temperature water side, a flow passageway 8 for circulating a constant temperature water for removing the heat from the Peltier device 7, and a temperature detector 9 for detecting the temperature of the wafer 4. Denoted at 10 and 11 are an outlet port and an inlet port for the constant temperature water, respectively, provided on the wafer table 5; at 13 is a constant temperature water circulating device for circulating the constant temperature water; and at 12 is a flow rate controlling valve for controlling the flow rate of the constant temperature water. The flow rate of the constant temperature water from the circulating device 13 is controlled by the flow rate controlling valve 12 and, thereafter, the water is supplied from the inlet 11 into the wafer table 5. From the wafer table 5, the water is flown through the outlet 10 back to the circulating device 13. Denoted at 14 is a shutter drive for actuating the shutter 2; and at 15 is a shutter control for controlling the opening/closing of the shutter 2 to thereby control the amount of exposure of the mask 3 and the wafer 4 to the exposure radiation rays 1 and to control the transfer of a pattern of the mask 3 to the wafer 4. The exposure apparatus of the illustrated embodiment is of step-and-repeat type, and in response to completion of exposure of a certain zone of the wafer 4, the wafer 4 is displaced with the wafer table 5 along the X-Y plane by a predetermined distance so that the next zone of the wafer 4 is placed at the exposure station. Such step-and-repeat movement is repeated until all the zones of the wafer are exposed. Denoted at 16 is a temperature measuring portion for measuring the temperature by use of the temperature detector 9. Denoted at 17 is an actuator for the Peltier device 7; at 18 is a Peltier device control; at 19 is a flow rate controller for controlling the flow rate controlling valve 12; and at 20 is a central processing unit (CPU) for controlling various controllers as mentioned above. Also, denoted at 25 is a wafer table drive, including an X-Y stage of well-known type, for moving the wafer table 5 in the X-axis and Y-axis directions for the alignment of the wafer 4 with the mask 3 and/or for the step-and-repeat exposures of the wafer 4.

The operation of the above-described structure will be explained.

First, as the information for the control of the wafer temperature, the temperature of the wafer 4 is measured by the temperature detector 9, and a signal representing the result of measurement is transmitted from the temperature measuring portion 16 to the Peltier device controller 18. In response to reception of the signal, the Peltier device controller 18 actuates the Peltier device 7 through the actuator 17, such that the heat at the wafer 4 side of the Peltier device 7 is transmitted to the constant temperature water side, whereby the temperature of the wafer 4 is controlled to and kept always at a predetermined temperature (for example, 23 ± 0.01 °C).

On the other hand, the constant temperature circulating device 13 supplies a constant temperature water whose temperature is controlled to a predetermined, for example, 23.1 ± 0.1 °C. The supplied constant temperature water is introduced from the flow rate controlling valve 12 and through the inlet 11, into the flow passageway 8, and removes the heat at the bottom side of the Peltier device 7 (a side thereof remote from the wafer 4). After this, the water is discharged through the outlet 10 back to the constant water circulating device 13.

The circulation of the constant temperature circulating water is stopped during the exposure period of the mask 3 and the wafer 4 to the exposure radiation rays 1 and, also, during the alignment period for the mask 3 and the wafer 4. During a time period other than those, for example, during the stepwise movement period of the wafer 4 or replacement of the wafer 4 on the wafer table 5, the circulation of the constant temperature water is executed. Hereinafter, such a period will be referred to as a "non-exposure period".

During the exposure period, the circulation of the constant temperature water is stopped. However, by the actuation of the Peltier device 7, the temperature of the wafer 4 can be maintained constant. Also, since the circulation of the constant temperature water is stopped at this time, substantially no vibration occurs in the wafer table 5. It is to be noted however that any heat produced at this time by the irradiation with the exposure radiation rays 1 is not discharged outwardly of the wafer table 5 by the constant temperature water. As a result, the temperature at the bottom side of the Peltier device 7 increases. In consideration thereof, during a non-exposure period after completion of the exposure of a current zone and before start of the exposure or the alignment of the next zone of the wafer, the CPU 20 supplies an instruction signal to the controller 19 so as to decrease the temperature at the bottom side of the Peltier device 7 back to the temperature substantially the same as that as assumed before the exposure operation or, alternatively, to a predetermined temperature substantially the same as that of the wafer 4, and through the flow rate controller 19 and thus the flow rate adjusting valve 12, controlled flow rate of the constant temperature water is flown.

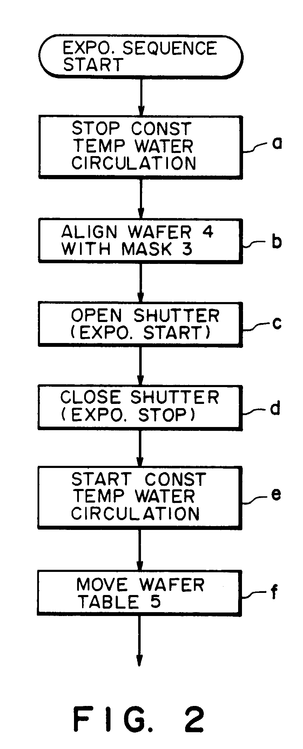

Next, the sequence of the exposure operation will be explained by reference to the flow chart of Figure 2. When the exposure sequence starts, first the circulation of the constant temperature water by the circulating device 13 is stopped (step a). This is done by stopping the operation of the circulating device 13 and/or by closing the flow rate adjusting valve 12. Subsequently, the position of the wafer table 5 is adjusted by the wafer table drive 25 (step b) so as to assure that the pattern of the mask 3 can be transferred to a predetermined site on the wafer 4. After this, the shutter 2 is opened for a predetermined time period, and the exposure starts (step c). After elapse of the predetermined time for exposure of the mask 3 and the wafer 4, the shutter 2 is closed and the exposure is finished (step d). After this, the circulation of the constant temperature water by the circulating device 13 is started (step e). This is done by re-starting the operation of the circulating device 13 and/or by opening the flow rate adjusting valve 12. Subsequently, the wafer table 5 is moved stepwise by the wafer table drive 25 along the X-Y plane through a predetermined distance (step f), to allow exposure of the next zone of the wafer 4. Then, the sequence goes back to step a and a similar exposure operation is repeated until the exposures of all the zones of the wafer 4 are completed.

During the execution of the above-described exposure operation sequence, as described, the Peltier device 7 is actuated continuously so as to maintain the wafer 4 constantly at a predetermined temperature.

While the foregoing description has been made of an example wherein the circulation of the water is stopped during the alignment operation period and the exposure operation period, the circulation of the constant temperature water itself may be executed provided that it does not produce vibration of the wafer table 5 of a degree influential to the alignment precision for the mask 3 and the wafer 4 or the resolution of the pattern transferred from the mask 3 to the wafer 4. In that occasion, the flow rate of the constant temperature water from the circulating device 13 is controlled by the opening/closing of the flow rate controlling valve 12, in such manner that a high flow rate is provided during the non-exposure period and a low flow rate is provided during the exposure period or the alignment period.

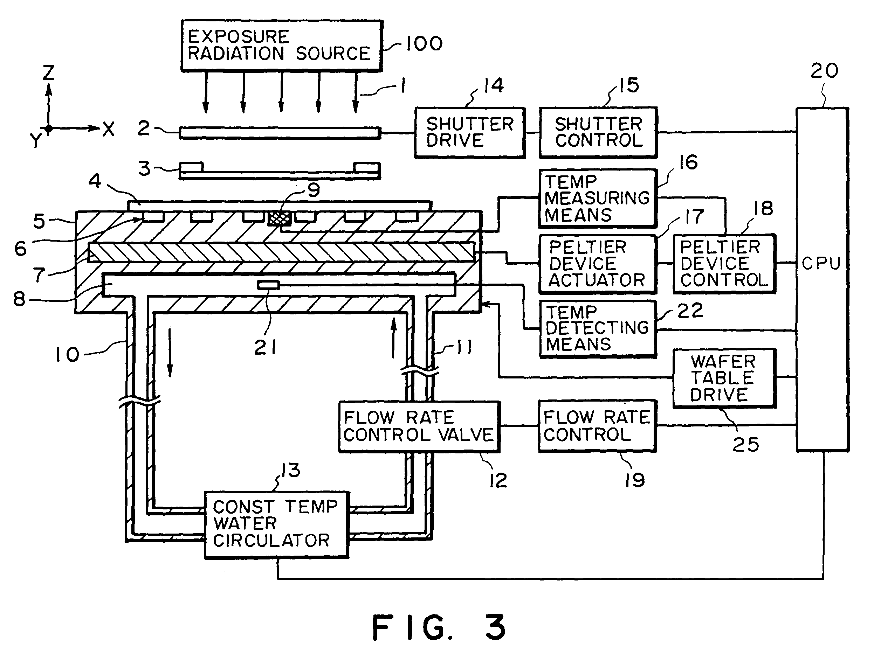

Figure 3 shows another embodiment of the present invention, wherein denoted at 21 is a temperature detector for measuring the temperature of the constant-temperature water within the flow passageway 8 as formed in the wafer table 5. The measured value is transmitted through the temperature measuring portion 22 to the CPU 20. The structure of the remaining part of this embodiment is essentially the same as that of the Figure 1 embodiment.

In the structure described above, after completion of the exposure at step d in Figure 2, in a processing step corresponding to the above-described step e an instruction signal is supplied by the CPU 20 to the flow rate controller 19 to ensure that the temperature of the constant temperature water inside the wafer table 5 is controlled to a predetermined temperature, namely, the temperature as measured by the temperature detector 21 becomes equal to the predetermined temperature. In response, through the flow rate controller 19, the flow rate adjusting valve 12 is opened or closed, whereby the quantity of the constant temperature water supplied to the wafer table 5 is adjusted. It is to be noted here that the higher the temperature as measured by the detector 21 after completion of the exposure is, the larger the opening of the flow rate adjusting valve 12 as instructed from the CPU 20 to the controller 19 is. This is for the reason that, if the temperature of the circulating water after completion of exposure is high, it is desirable to increase the flow rate to remove the heat from the wafer table 5 quickly. When the temperature measuring portion 22 discriminates through the temperature detector 21 that the temperature of the circulating water in the wafer table 5 has come to the predetermined temperature, CPU 20 operates to start the exposure sequence at step a in Figure 2.

In this occasion, however, it is not always necessary that the predetermined temperature set to the constant temperature water within the wafer table 5 is equal to the predetermined temperature set to the wafer 4. Also, it is not always necessary that the temperature of the constant temperature water as circulated from the circulating device 13 is equal to the set temperature of the wafer 4.

For example, when the set temperature of the wafer 4 is 23 ± 0.01 °C, a constant temperature water of 22 ± 0.1 °C may be supplied from the constant temperature water circulating device 13. In this occasion, when the shutter 2 is closed and the exposure radiation rays 1 do not impinge on the wafer 4, it is possible that the temperature of the wafer 4 is lower than the set temperature (23 ± 0.01 °C).

In consideration thereof, in this occasion, the polarity of the Peltier device 7 may be inverted so that the Peltier device may operate as a heater to increase the temperature of the wafer 4 to the predetermined. Then, since, in response to the start of exposure, thermal energy is applied to the wafer 4 by the exposure radiation rays 1, the Peltier device 7 may be operated as a heat pump to discharge the heat at the wafer 4 side to the constant temperature side in the flow passageway 8, to thereby prevent temperature rise in the wafer 4.

The temperature of the constant temperature water within the wafer table 5, as measured by the temperature detector 21, is fed back to the circulating device 13 and, in response, the circulating device 13 controls the temperature of the water, being supplied therefrom, so as to assure that the water as it is within the wafer table 5 has a temperature equal to a predetermined temperature.

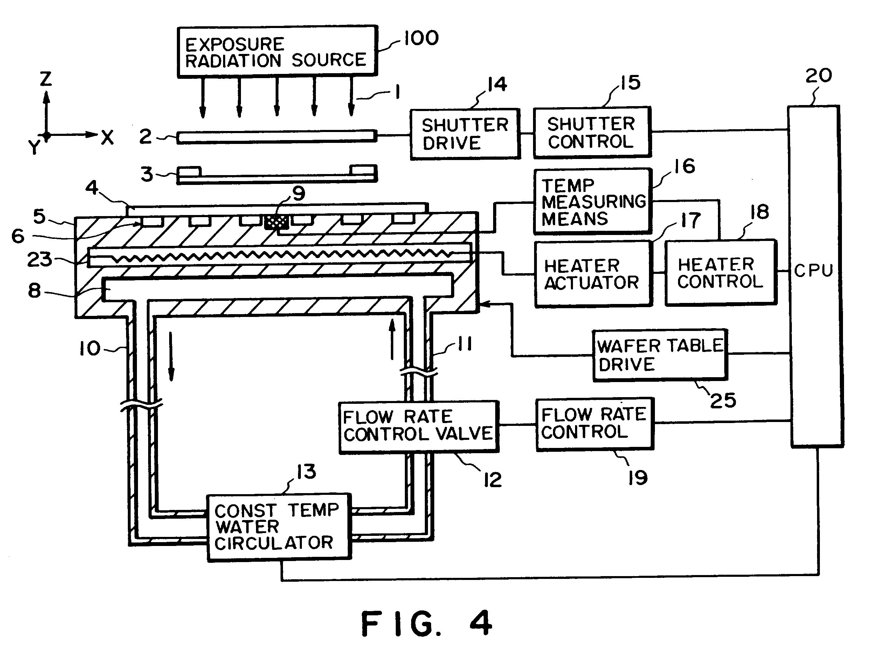

Figure 4 shows a further embodiment, wherein the Peltier device 7 is replaced by a heater 23. The remaining part of this embodiment is essentially the same as that of the Figure 1 embodiment.

In this embodiment, the temperature of the constant temperature water is determined so that, when the circulation of the constant temperature water through the circulating device 13 is stopped and when the heater 23 is not actuated, a wafer 4 is maintained during the exposure period at a temperature not higher than a set temperature of 23 °C. For example, if the temperature rise of the wafer 4 during the exposure period is 1.5 (deg), the temperature of the constant temperature water to be supplied from the constant temperature water circulating device 13 is set to a level (e.g. 21 °C), lower than 21.5 °C. Then, the heater 23 is energized during the exposure period of the wafer 4 so as to assure that the wafer 4 is maintained throughout the exposure period (from the start to the end of the exposure) constantly at the set temperature of 23 ± 0.01 °C. More specifically, if, just after start of the exposure, the temperature of the wafer 4 is not increased to the set temperature only by the application of the energy with the irradiation of the exposure radiation rays 1, the heat generation of the heater 23 is increased to attain the set temperature of the wafer 4. As the total exposure amount of the wafer 4 with the irradiation by the exposure radiation rays 1 increases, with the lapse of time, the temperature of the wafer 4 rises and, therefore, the heat generation of the heater 23 is reduced gradually, whereby even just before completion of the exposure, the wafer 4 can be retained at the set temperature. The circulation of the constant temperature water during the exposure period and the non-exposure period, is the same as that of the Figure 1 embodiment.

While the foregoing description has been made to examples wherein a Peltier device or a heater is used as a temperature controlling means for the constant temperature circulating water, in place of such devices, a temperature controlling means, such as a heat pipe, for example, of the type in which any vibration thereof is very small and can be disregarded as compared with that to be produced by circulation of the constant temperature water, may effectively be used. Also, it is not always necessary to use the water as the heat removing means for discharging the heat of the wafer table 5 outwardly, and any other cooling medium may be used.

Further, while in the preceding embodiments, description has been made to an example wherein the wafer temperature during the exposure period is controlled to a constant level, since with the wafer table of the present invention the temperature of the wafer 4 can be set during the exposure period at a desired level substantially without vibration, the wafer table of the present invention can be effectively used in such system wherein means is provided to change the temperature of a wafer for expansion/contraction of the wafer so as to correct the distortion of the wafer, if any, produced during a process other than the exposure process, such as disclosed in the aforementioned Japanese Laid-Open Patent Application 53-15768 for example.

Further, the invention is not limited to a wafer table in a photolithographic apparatus, but it is effectively applicable also to a wafer table in an apparatus, such as an electron beam pattern drawing apparatus, wherein precise positioning is required.

With the provision of a temperature controlling means for precisely controlling the temperature of a wafer substantially without vibration and a temperature controlling means capable of removing, outwardly, the heat in the wafer table as supplied from the outside, and of controlling the flow rate of the medium in accordance with the state of exposure, in the present invention, it is possible to maintain the wafer temperature at a desired level and, additionally, it is possible to prevent degradation of the pattern printing precision due to vibration during the exposure period. As a result, the wafer processing such as high-precision patterning thereof, for example, is ensured.

## Claims

1. An exposure apparatus for exposing a wafer (4) with radiation, comprising a table (5) having a holding surface for holding said wafer (4); a flow passageway (8) through which temperature adjusting medium can flow to remove heat in said table (5); a temperature adjusting device (7, 23) disposed between said holding surface and said flow passageway (8) and adapted to actively heat or cool said holding surface; and flow rate controlling means (12, 19) for controlling the flow rate of said temperature adjusting medium circulated through said flow passageway (8);
characterised by control means (20) adapted to control said flow rate controlling means (12, 19) to decrease the flow rate of said temperature adjusting medium during an exposure period in which said wafer (4) is exposed with the radiation and/or during aligning of said wafer (4) on said table (5) as compared with the flow rate during a non exposure and/or non alignment period such that any vibration resulting from the flow of said temperature adjusting medium is not substantially influential to the exposure precision and/or the alignment precision.

2. An apparatus as claimed in claim 1, characterised in that a temperature detector (21) is provided along said flow passageway (8), for measuring the temperature of said temperature adjusting medium in said flow passageway (8).

3. An apparatus as claimed in claim 1 or 2, characterised in that said temperature adjusting device (7) comprises a Peltier element.

4. An apparatus as claimed in claim 1, characterised in that said temperature adjusting device comprises a heating element (23).

5. An apparatus as claimed in claim 1, characterised by a radiation source (100) for generating the exposure radiation.

6. An exposure method for exposing a wafer (4) with radiation (1), comprising holding said wafer (4) on a wafer holding surface of a table (5) with attraction; actively heating or cooling said wafer (4) held by said wafer holding surface using a temperature adjusting device (7,23), said temperature adjusting device (7,23) being disposed between said wafer holding surface and a flow passageway (8) through which a temperature adjusting medium can flow for removal of heat in said table (5); characterised in that whilst said wafer (4) is exposed with the radiation (1) and/or said wafer (4) is aligned on said table (5), the flow rate of the temperature adjusting medium supplied through said flow passageway (8) is reduced, as compared with the flow rate of the temperature adjusting medium flowing through said flow passageway (8) during a period in which said wafer (4) is not exposed with the radiation and/or aligned on said table (5) such that any vibration resulting from the flow of the temperature adjusting medium is not substantially influential to the exposure precision and/or the alignment precision.

7. A method as claimed in claim 6, characterised in that the temperature of the temperature adjusting medium in said flow passageway (8) is measured.

8. A method as claimed in claim 7, characterised in that the temperature of the temperature adjusting medium in said flow passageway (8) is controlled to a predetermined level on the basis of the measurement.

## Patentansprüche

1. Belichtungsvorrichtung zur Belichtung eines Wafers (4) mit Strahlung, die einen Tisch (5) mit einer Halteoberfläche zum Halten des Wafers (4), einen Strömungsdurchgang (8), durch den ein Temperaturjustiermedium zum Abführen von Wärme in dem Tisch (5) fließen kann, eine Temperaturjustiereinrichtung (7, 23), die zwischen der Halteoberfläche und dem Strömungsdurchgang (8) angeordnet ist und die Halteoberfläche aktiv erhitzt oder kühlt, und eine Strömungsgeschwindigkeits-Steuereinrichtung (12, 19) zur Steuerung der Strömungsgeschwindigkeit des durch den Strömungsdurchgang (8) zirkulierenden Temperaturjustiermediums aufweist,
**gekennzeichnet durch**
eine Steuereinrichtung (20) zur Steuerung der Strömungsgeschwindigkeits-Steuereinrichtung (12, 19), damit die Strömungsgeschwindigkeit des Temperaturjustiermediums während einer Belichtungsperiode, in der der Wafer (4) mit der Strahlung belichtet wird, und/oder während eines Ausrichtens des Wafers (4) an dem Tisch (5) im Vergleich zu der Strömungsgeschwindigkeit während einer Periode, in der nicht belichtet und/oder nicht ausgerichtet wird, derart verringert wird, daß jede aus der Strömung des Temperaturjustiermediums folgende Vibration keinen wesentlichen Einfluß auf die Belichtungsgenauigkeit und/oder die Ausrichtungsgenauigkeit hat.

2. Vorrichtung nach Anspruch 1,
**dadurch gekennzeichnet, daß**
eine Temperaturerfassungseinrichtung (21) im Verlauf des Strömungsdurchgangs (8) zum Messen der Temperatur des Temperaturjustiermediums in dem Strömungsdurchgang (8) vorgesehen ist.

3. Vorrichtung nach Anspruch 1 oder 2,
**dadurch gekennzeichnet, daß**
die Temperaturjustiereinrichtung (7) ein Peltierelement aufweist.

4. Vorrichtung nach Anspruch 1,
**dadurch gekennzeichnet, daß**
die Temperaturjustiereinrichtung (7) ein Heizelement (23) aufweist.

5. Vorrichtung nach Anspruch 1,
**gekennzeichnet durch**
eine Strahlungsquelle (100) zur Erzeugung der Belichtungsstrahlung.

6. Belichtungsverfahren zur Belichtung eines Wafers (4) mit Strahlung (1) mit Halten des Wafers (4) mittels Anziehung an einer Waferhalteoberfläche eines Tischs (5), aktives Erhitzen oder Kühlen des durch die Waferhalteoberfläche gehaltenen Wafers (4) unter Verwendung einer Temperaturjustiereinrichtung (7, 23), wobei die Temperaturjustiereinrichtung (7, 23) zwischen der Waferhalteoberfläche und einem Strömungsdurchgang (8), durch den ein Temperaturjustiermedium zum Abführen von Wärme in dem Tisch (5) fließen kann, angeordnet ist, **dadurch gekennzeichnet, daß**
während der Wafer (4) mit der Strahlung (1) belichtet und/oder der Wafer (4) an dem Tisch (5) ausgerichtet wird, die Strömungsgeschwindigkeit des durch den Strömungsdurchgang (8) transportierten Temperaturjustiermediums im Vergleich zu der Strömungsgeschwindigkeit des Temperaturjustiermediums, das während einer Periode, in der der Wafer (4) nicht mit der Strahlung belichtet und/oder an dem Tisch ausgerichtet wird, durch den Strömungsdurchgang (8) fließt, derart verringert ist, daß jede aus dem Strömung des Temperaturjustiermediums folgende Vibration keinen wesentlichen Einfluß auf die Belichtungsgenauigkeit und/oder die Ausrichtungsgenauigkeit hat.

7. Verfahren nach Anspruch 6,
**dadurch gekennzeichnet, daß**
die Temperatur des Temperaturjustiermediums in dem Strömungsdurchgang (8) gemessen wird.

8. Verfahren nach Anspruch 7,
**dadurch gekennzeichnet, daß**
die Temperatur des Temperaturjustiermediums in dem Strömungsdurchgang (8) auf der Grundlage der Messung auf einen vorbestimmten Pegel gesteuert wird.

## Revendications

1. Appareil d'exposition pour exposer une tranche (4) à un rayonnement, comportant une table (5) ayant une surface de maintien destinée à maintenir ladite tranche (4) ; un passage (8) d'écoulement par lequel un milieu de réglage de température peut s'écouler pour éliminer de la chaleur dans ladite table (5) ; un dispositif (7, 23) de réglage de température disposé entre ladite surface de maintien et ledit passage (8) d'écoulement et conçu pour chauffer ou refroidir activement ladite surface de maintien, et des moyens (12, 19) de régulation de débit d'écoulement destinés à réguler le débit d'écoulement dudit milieu de réglage de température mis en circulation dans ledit passage d'écoulement (8) ;
caractérisé par des moyens de commande (20) destinés à commander lesdits moyens (12, 19) de régulation de débit d'écoulement pour diminuer le débit d'écoulement dudit milieu de réglage de température pendant une période d'exposition au cours de laquelle ladite tranche (4) est exposée au rayonnement et/ou pendant un alignement de ladite tranche (4) sur ladite table (5), en comparaison avec ledit débit d'écoulement pendant une période de non-exposition et/ou de non-alignement afin que toute vibration résultant de l'écoulement dudit milieu de réglage de température n'ait pratiquement aucune influence sur la précision de l'exposition et/ou la précision de l'alignement.

2. Appareil selon la revendication 1, caractérisé en ce qu'un détecteur (21) de température est prévu le long dudit passage (8) d'écoulement, pour mesurer la température dudit milieu de réglage de température dans ledit passage (8) d'écoulement.

3. Appareil selon la revendication 1 ou 2, caractérisé en ce que ledit dispositif (7) de réglage de température comporte un élément à effet Peltier.

4. Appareil selon la revendication 1, caractérisé en ce que ledit dispositif de réglage de température comporte un élément chauffant (23).

5. Appareil selon la revendication 1, caractérisé par une source (100) de rayonnement destinée à générer le rayonnement d'exposition.

6. Procédé d'exposition pour exposer une tranche (4) à un rayonnement (1), comprenant le maintien par une attraction de ladite tranche (4) sur une surface de maintien de tranche présentée par une table (5) ; le chauffage ou le refroidissement actif de ladite tranche (4) maintenue par ladite surface de maintien de tranche en utilisant un dispositif (7, 23) de réglage de température, ledit dispositif (7, 23) de réglage de température étant disposé entre ladite surface de maintien de tranche et un passage d'écoulement (8) dans lequel un milieu de réglage de température peut s'écouler pour éliminer de la chaleur dans ladite table (5) ; caractérisé en ce que, pendant que ladite tranche (4) est exposée au rayonnement (1) et/ou que ladite tranche (4) est alignée sur ladite table (5), le débit d'écoulement du milieu de réglage de température mis en circulation dans ledit passage (8) d'écoulement est réduit, en comparaison avec le débit d'écoulement du milieu de réglage de température s'écoulant dans ledit passage (8) d'écoulement pendant une période au cours de laquelle ladite tranche (4) n'est pas exposée au rayonnement et/ou n'est pas alignée sur ladite table (5), afin que toute vibration résultant de l'écoulement du milieu de réglage de température n'ait pratiquement aucun effet sur la précision de l'exposition et/ou la précision de l'alignement.

7. Procédé selon la revendication 6, caractérisé en ce que la température du milieu de réglage de température dans ledit passage d'écoulement (8) est mesuré.

8. Procédé selon la revendication 7, caractérisé en ce que la température du milieu de réglage de température dans ledit passage d'écoulement (8) est régulée à un niveau prédéterminé sur la base de la mesure.
